# EUROPEAN PATENT APPLICATION

(11) **EP 3 474 332 A1**
(43) Date of publication of application: **24.04.2019**
(21) Application number: 18174376.6
(22) Date of filing: 25.05.2018
(51) Int. Cl.: H01L 31/048, B32B 27/00, H01L 51/44

(54) **STRESS RELEASE METHOD AND DEVICE FOR PACKAGING FILM OF FLEXIBLE PHOTOVOLTAIC MODULE**

(30) Priority: 20.10.2017 CN 201710984963
(71) Applicant: Miasolé Equipment Integration (Fujian) Co., Ltd., 362005 Quanzhou Fujian (CN)
(72) Inventor: LI, Tao, Quanzhou, Fujian 362005 (CN); ZENG, Jing, Quanzhou, Fujian 362005 (CN); LIU, Lin, Quanzhou, Fujian 362005 (CN); YUAN, Qiang, Quanzhou, Fujian 362005 (CN); SUN, Shiyang, Quanzhou, Fujian 362005 (CN); XU, Guojun, Quanzhou, Fujian 362005 (CN); LIAN, Chongyan, Quanzhou, Fujian 362005 (CN)
(74) Representative: Allain, Laurent

(57) **Abstract**

The disclosure provides a stress release method and device for packaging film of flexible photovoltaic module. The method comprises: placing (S100) a film (500) to be cut on a loading platform (100); cutting (S200) the film (500) with an insert (300) such that an incision (510) inclined relative to an edge of the film (500) is formed on the film (500); and activating (S300) the feeding mechanism and driving the film (500) to move along an axial direction thereof such that the insert (300) moves out of the incision (510) to a next position to be cut on the film (500). The stress release method and device according to the embodiments of the present disclosure can realize the release of the stress and shrinkage of the packaging film without changing the amount of the material of the packaging film, such that the risk of wrinkling during subsequent processing can be reduced.

## Description

### CROSS-REFERENCE TO RELATED APPLICATIONS

This application claims priority to Chinese Patent Application No. 201710984963.3 filed on October 20, 2017 in the State Intellectual Property Office of China, the entire contents of which are incorporated herein by reference.

### FIELD OF THE INVENTION

The present disclosure relates to the technical field of solar cell processing, and in particular, to a stress release method and device for a packaging film of a flexible photovoltaic module.

### BACKGROUND

Comparing to conventional rigid solar cell modules, the flexible solar cell module is light, thin and bendable, and has a wider range of applications. However, the appearance of flexible module is more sensitive to environmental temperature, humidity, and lamination processes. Due to the shrinkage and stress of the flexible packaging material and the compatibility of materials, the surface of the flexible module is inclined to be wrinkled, which seriously affects the appearance of the module.

During the lamination processes of the module, the packaging material is subject to shrinkage due to its own stress when being heated. The larger the module, the greater the shrinkage of the packaging material. The difference in material shrinkages directly leads to a dimensional difference in materials having various shrinkage indices. Due to effects of adhesive force and internal stress between the packaging materials, a margin would occur in a local area of the material having a small shrinkage index, thereby forming an appearance with partial wrinkles and bulging deformation. At present, the flexible solar module is a new and developing article, so that no effective solution has been proposed for the wrinkles of flexible module in the industry.

### SUMMARY

An objective of the present disclosure is to provide a stress release method and device for packaging film of flexible photovoltaic module, so as to realize unordered release of stress and shrinkage of the packaging film during lamination heating without changing the amount of the packaging film material to reduce the risk of wrinkles.

The disclosure provides a stress release method for packaging film of flexible photovoltaic module, comprising steps of: placing (S100) a film (500) to be cut on a loading platform (100); and cutting (S200) the film (500) with an insert (300) such that an incision (510) inclined relative to an edge of the film (500) is formed on the film (500).

According to the stress release method for packaging film of flexible photovoltaic module, preferably, wherein the step of placing (S100) a film (500) to be cut on a loading platform (100) comprises: placing the film (500) to be cut onto a feeding mechanism.

According to the stress release method for packaging film of flexible photovoltaic module, preferably, after cutting (S200) the film (500) with an insert (300) such that an incision (510) inclined relative to an edge of the film is formed on the film, the method further comprises: activating (S300) the feeding mechanism and driving the film (500) to move along an axial direction thereof such that the insert (300) moves out of the incision (510) to a next position to be cut on the film (500).

According to the stress release method for packaging film of flexible photovoltaic module, preferably, before placing (S100) a film to be cut on a loading platform (100), the method further comprises: rolling (S1) the film (500) into a cylinder-shaped film roll.

According to the stress release method for packaging film of flexible photovoltaic module, preferably, the step of cutting (S200) the film with an insert (300) comprises: rotating (S220) the insert (300) disposed on a rotary mechanism along a direction of the film to form the incision (510) on the film (500); and rotating (S230) the insert (300) along a direction away from the film (500), after the incision (510) is formed.

According to the stress release method for packaging film of flexible photovoltaic module, preferably, before rotating (S220) the insert (300) disposed on a rotary mechanism along a direction of the film to form the incision (510) on the film (500), the method further comprises: rotating (S210) the rotary mechanism to adjust a cutting angle of the insert (300).

According to the stress release method for packaging film of flexible photovoltaic module, preferably, before rotating (S210) the rotary mechanism to adjust a cutting angle of the insert (300), the method further comprises: adjusting (S10) a length of a handle to adjust an angle between two inserts (300).

According to the stress release method for packaging film of flexible photovoltaic module, preferably, the step of activating (S300) the feeding mechanism and driving the film (500) to move along an axial direction thereof such that the insert (300) moves out of the incision (510) to a next position to be cut on the film (500) comprises: sending (S310) an insert return signal from a detection device to a stepper motor; and activating (S320) the stepper motor to drive a clamping structure to move a predetermined step.

The disclosure also provides a stress release device for packaging film of flexible photovoltaic module, comprising: a loading platform (100), configured to support a film (500); and an insert (300), configured to cut on the (500) to form an incision (510) inclined with respect to an edge of the film (500).

According to the stress release device for packaging film of flexible photovoltaic module, preferably, the device further comprises a rotary mechanism (200) rotatably disposed on the loading platform (100), and one end of the insert (300) is rotatably connected to the rotary mechanism (200), such that an angle is formed between the insert (300) and the rotary mechanism (200).

According to the stress release device for packaging film of flexible photovoltaic module, preferably, the rotary mechanism (200) comprises a rotary pillar (210) and a rotatable shaft (220). Further, one end of the rotary pillar (210) is rotatably connected to the loading platform (100), the rotatable shaft (220) is rotatably connected to the rotary pillar (210), an axis of the rotatable shaft (220) is perpendicular to an axis of the rotary pillar (210), and one end of the insert (300) is connected to the rotatable shaft (220).

According to the stress release device for packaging film of flexible photovoltaic module, preferably, the rotary mechanism (200) further comprises a fixed shaft (230) fixedly disposed at an end of the rotatable shaft (220) such that an axis of the fixed shaft (230) is perpendicular to the axis of the rotatable shaft (220), and one end of the insert (300) is rotatably connected to the fixed shaft (230).

According to the stress release device for packaging film of flexible photovoltaic module, preferably, two inserts (300) that are centro-symmetrically arranged about the axis of the rotary pillar (210) are provided.

According to the stress release device for packaging film of flexible photovoltaic module, preferably, an angle between the two inserts (300) ranges from 30° to 150°.

According to the stress release device for packaging film of flexible photovoltaic module, preferably, the device further comprises a handle (400) having a first arc segment (410) and a second arc segment (420), wherein one end of the first arc segment (410) is fixedly connected to one insert (300), the other end of the first arc segment (410) is slidably connected to one end of the second arc segment (420) and the other end of the second arc segment (420) is fixedly connected to the other insert (300).

According to the stress release device for packaging film of flexible photovoltaic module, preferably, a chute (411) is disposed on the first arc segment (410), and a position scale (412) is disposed on an edge of the chute (411); a guide tab (421) is disposed at an end of the second arc section (420) close to the first arc section (410), and is slidably connected to the chute (411); and a pointer (422) is disposed at an end of the guide tab (421) and the is aligned with a scale on the position scale (412).

According to the stress release device for packaging film of flexible photovoltaic module, preferably, an angle scale (110) is disposed around the rotary pillar (210) on the loading platform (100), and one end of the rotary pillar (210) close to the loading platform (100) is provided with an indicating protrusion aligned with a scale on the angle scale (110).

According to the stress release device for packaging film of flexible photovoltaic module, preferably, a buffer layer is disposed on the loading platform (100).

According to the stress release device for packaging film of flexible photovoltaic module, preferably, the loading platform (100) is provided with a feeding mechanism comprising a stepper motor, a detection device, and a clamping structure; the loading platform (100) is provided with a chute feeder; the stepper motor is configured to drive the clamping structure to slide in the chute feeder; the detection device is fixed on the loading platform (100); and the detection device is configured to detect a position of the insert (300).

The stress release method and device of the packaging film of flexible photovoltaic module according to the present disclosure can realize the release of the stress and shrinkage of the packaging film without changing the amount of the material of the packaging film, such that the risk of wrinkling during subsequent processing can be reduced. At the same time, through the automatic feeding of the packaging film, the cutting efficiency and cutting accuracy of the packaging film can be improved, the uniformity of the distribution of the incisions can be ensured, and the stress releasing effect can be enhanced.

### BRIEF DESCRIPTION OF THE DRAWINGS

FIG. 1 is a flow chart of a stress release method for packaging film of flexible photovoltaic module according to an embodiment of the present disclosure;
FIG. 2 is a schematic structural diagram of a stress release device for packaging film of flexible photovoltaic module according to an embodiment of the present disclosure;
FIG. 3 is a diagram showing a state of the packaging film before cutting;
FIG. 4 is a diagram showing a state of the packaging film after cutting;
FIG. 5 is a schematic structural diagram of a rotary mechanism; and
FIG. 6 is a schematic structural diagram of a handle.

### Description of the reference numerals:

| | | |
|---|---|---|
| 100-loading platform | 110-angle scale | 200-rotary mechanism |
| 210-rotary pillar | 220-rotatable shaft | 230-fixed shaft |
| 300-insert | 400-handle | 410-first arc segment |
| 411-chute | 412 - position scale | 420 - second arc segment |
| 421-guide tab | 422 - pointer | 500 - packaging film |
| 510-incision | | |

### DETAILED DESCRIPTION OF THE EMBODIMENTS

Exemplary embodiments of the present disclosure will be described in detail below with reference to the accompanying drawings. In the drawings, examples of the embodiments are illustrated in the accompanying drawings, wherein the same or similar reference numerals are used throughout to designate the same or similar elements or elements having the same or similar functions. It should be understood that the following exemplary embodiments described with reference to the accompanying drawings are only for explaining the present disclosure and should not be construed as limiting the present disclosure.

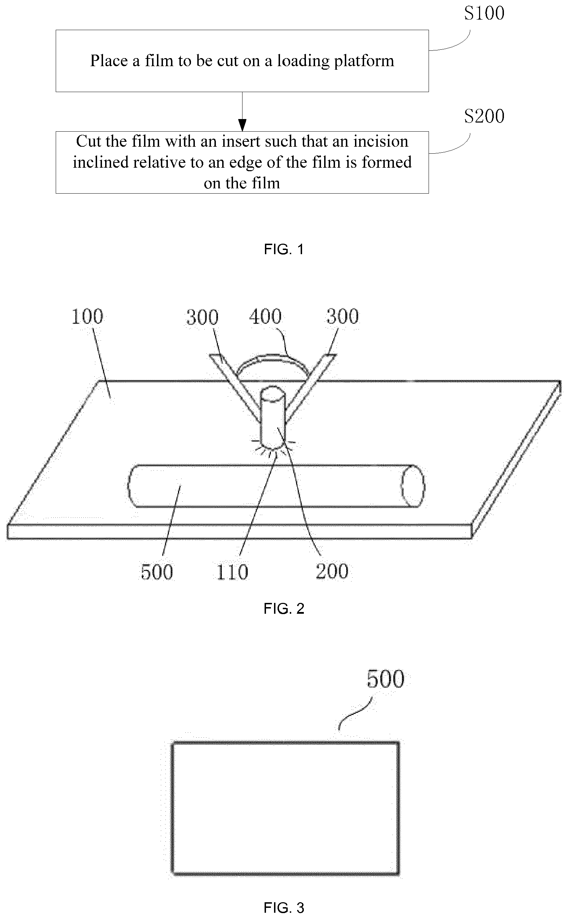

As shown in FIG. 1, an embodiment of the present disclosure provides a stress release method for packaging film of flexible photovoltaic module, comprising steps of:
S100, placing a film to be cut on a loading platform.

Specifically, Step S100 includes: placing the film to be cut onto a feeding mechanism.

In an exemplary embodiment, prior to Step S100, the method further includes a step of:
S1, rolling the film into a cylinder-shaped film roll.

S200, cutting the film with an insert such that an incision inclined relative to an edge of the film is formed on the film.

It should be noted that the film may have a certain degree of shrinkage. In this embodiment, the film is a packaging film. The packaging film is usually a flat rectangular film, as shown in FIG. 3. However, when cutting on the flat film, only one incision can be cut at one time. In order to cut a plurality of uniformly distributed incisions on the packaging film at one time, the packaging film may be rolled into a cylindrical shape before the packaging film is placed on the feeding mechanism. After the packaging film in the cylindrical shape is cut, a plurality of uniformly distributed incisions can be formed as the packaging film is unfolded. In addition, since the packaging film has a certain degree of flexibility, when being cut with the insert, the cylindrical packaging film is first compressed and deformed by a pressure of the insert. When the packaging film is deformed to its limit, the insert begins to cut out the incision. Since the packaging film can be made from different kinds of materials, in order to prevent the packaging film rolled into the cylindrical shape from collapsing due to deformation, the packaging films can be rolled into cylinders having different diameters according to the material and the shrinkage index.

In an exemplary embodiment, Step S200 specifically includes:
S210, rotating a rotary mechanism to adjust a cutting angle of the insert.

When the rotary mechanism is rotated by different angles, the cutting angle of the insert is also changed. In other words, different positions of the insert on the packaging film can obtain incisions with different lengths and angles on the packaging film. The cutting angle can be specifically determined according to different packaging films, so as to meet cutting requirements of various types of packaging films.

It should be noted that the incisions are not parallel to four edges of the packaging film, so as to prevent the incisions from being parallel or substantially parallel to a direction of internal stress of the packaging film. In this way, it is possible to eliminate the problem that the incisions cannot be filled with the packaging film to result in a lack of adhesive. Preferably, an angle between the incision and the edge of the packaging film is no less than 10°.

S220, rotating the insert disposed on the rotary mechanism along a direction of the film roll to form the incision on the film roll.

S230, rotating the insert along a direction away from the film roll to separate the insert from the film roll, after the incision is formed.

Further, following Step S200, the method includes:
S300, activating the feeding mechanism and driving the film roll to move along an axial direction thereof such that the insert moves out of the incision to a next position to be cut on the film roll.

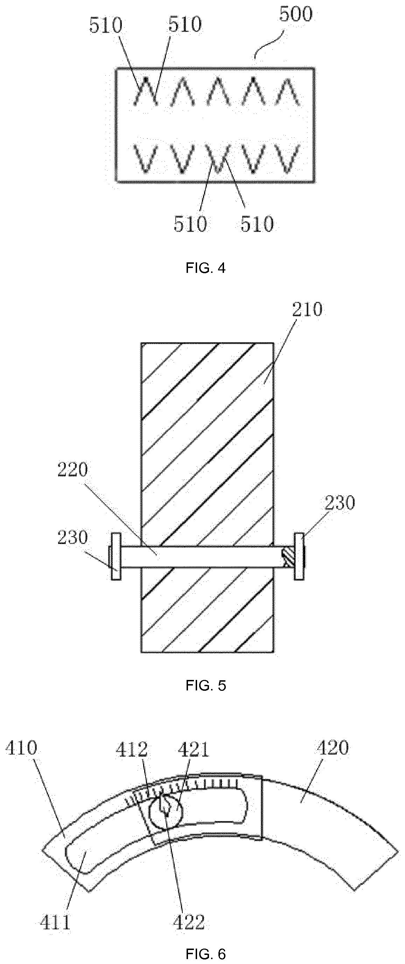

That is, for example, after a first incision is formed, the film roll is moved by the feeding mechanism to perform the cutting of a second incision; after the second incision is completed, the film roll is moved again to perform the cutting of a third incision; the above processes are repeated until multiple incisions are formed on the film roll, as shown in FIG. 4. In this way, the stress on the film roll can be effectively released and the film roll can be prevented from being wrinkled during subsequent processing. The number of incisions may be determined according to the actual processing requirements of the film roll. Of course, in the case where less incisions are needed, an operator can also realize the feeding by manually driving the feeding mechanism.

It should be noted that two inserts can be symmetrically provided, which is connected by a handle with an adjustable length. Before the rotary mechanism is rotated to adjust the cutting angle, the method may further include:
S10, adjusting a length of a handle to adjust the angle between the two inserts.

The operator can rotate the insert for cutting by manipulating the handle. Since the two inserts are connected by the handle, the inserts can move synchronously. If a symmetry plane of the two inserts are perpendicular to an axis of the cylindrical packaging film, the two inserts can form symmetrical incisions on the packaging film during the cutting process, as shown in FIG. 4, wherein an angle between two incisions is the angle between the two inserts. Thus, for different film rolls, a desirable angle of incisions can be obtained by adjusting a length of the handle, so that an excellent effect of releasing the stress can be achieved.

Further, Step S300 specifically includes:
S310: sending an insert return signal from a detection device to a stepper motor; and
S320: activating the stepper motor to drive a clamping structure to move a predetermined step.

Specifically, the detection device can detect an operating state of the insert. That is, when the insert is in the cutting state, the detection device issues a cutting signal; after receiving the cutting signal, the stepper motor maintains a static state to cut with the insert; when the cutting is completed, the insert is separated from the packaging film and returns to the in-situ. At this time, the detection device issues a cutting end signal, and after receiving the cutting end signal, the stepper motor starts to drive the clamping structure to move in a predetermined step. After moving for a predetermined step, the stepper motor stops operating so as to cut out a next incision with the insert, thereby realizing the automatic feeding of the packaging film and improving the cutting efficiency. At the same time, by moving the packaging film for a predetermined step, an equal interval can be maintained between two adjacent incisions, as shown in FIG. 4, such that all the incisions can be uniformly distributed on the packaging film and the stress release effect can be improved.

In an exemplary embodiment, the detection device may be a laser sensor, an infrared sensor, an ultrasonic sensor, for example. The detection device may determine a working state of the insert by detecting the position of the insert.

By the stress release method of the packaging film of flexible photovoltaic module according to the embodiment of the disclosure, the uncontrolled stress and the shrinkage of the packaging film during the laminating heating process can be released without changing the amount of the packaging film material, so that the risk of wrinkles can be reduced. At the same time, through the automatic feeding of the packaging film, the cutting efficiency and cutting accuracy of the packaging film can be improved, the uniformity of the distribution of the incision can be ensured, and the stress releasing effect can be enhanced.

As shown in FIG. 2, an embodiment of the present disclosure also provides a stress release device for packaging film of flexible photovoltaic module, comprising: a loading platform 100 and an insert 300, wherein the loading platform 100 is configured to support a film, and for convenience of feeding the film, the loading platform may be provided with a feeding mechanism; the insert 300 is configured to cut on the film to form an incision 510 inclined with respect to an edge of the film. The incision 510 may be filled with the packaging film 500. By providing the incision 510 on the packaging film 500, the release of internal stress in the packaging film 500 can be achieved, while the wrinkle of the packaging film 500 can be prevented during the subsequent processing.

Specifically, the stress release device of the packaging film of flexible photovoltaic module further includes a rotary mechanism 200 rotatably disposed on the loading platform 100. One end of the insert 300 is rotatably connected to the rotary mechanism 200 such that an angle is formed between the insert 300 and the rotary mechanism 200. In this manner, the incision 510 that is not parallel to edges of the packaging film 500 can be cut out to prevent the incision 510 from being parallel or substantially parallel to a direction of internal stress of the packaging film 500, thereby eliminating the fact that the incision 510 cannot be filled with the packaging film 500 to result in a lack of adhesive.

The operator can place the cylindrical packaging film 500 on the feeding mechanism and adjust the cutting angle of the insert 300 by rotating the rotary mechanism 200; after the adjustment is completed, the insert 300 is rotated along a direction of the packaging film to form the incision 510 on the packaging film 500; after the incision is formed, the insert 300 is rotated in a direction away from the packaging film 500 to separate the insert 300 from the packaging film 500; then the feeding mechanism is actuated to drive the packaging film 500 to move in an axial direction thereof so that the insert 300 moves out of the incision 510 to a next position to be cut on the packaging film 500. In this way, a plurality of incisions 510 can be formed. The stress release device of the packaging film of flexible photovoltaic module according to the embodiment of the present disclosure can realize the release of the stress and shrinkage of the packaging film 500 without changing the amount of the material of the packaging film 500, such that the risk of wrinkling during subsequent processing can be reduced. At the same time, through the automatic feeding of the packaging film 500, the cutting efficiency and cutting accuracy of the packaging film 500 can be improved, the uniformity of the distribution of the incision 510 can be ensured, and the stress releasing effect can be enhanced.

Further, the feeding mechanism includes a stepper motor, a detection device, and a clamping structure. The loading platform 100 is provided with a chute feeder. The clamping structure is configured to clamp the cylindrical packaging film 500, the stepper motor is configured to drive the clamping structure to slide in the chute feeder, the detection device fixed on the loading platform 100 is configured to detect a position of the insert 300.

Specifically, the detection device can detect an operating state of the insert 300. That is, when the insert 300 is in a cutting state, the detection device issues a cutting signal, and after receiving the cutting signal, the stepper motor maintains a static state to cut with the incision 300; when the cutting is completed, the incision 300 is separated from the packaging film 500 and return to the in-situ. At this time, the detection device issues a cutting end signal, and after receiving the cutting end signal, the stepper motor starts to drive the clamping structure to move in a predetermined step. After moving for a predetermined step, the stepper motor stops operating so as to cut out a next incision with the insert 300, thereby realizing the automatic feeding of the 500 and improving the cutting efficiency. At the same time, by moving the packaging film 500 for a predetermined step, an equal interval can be maintained between two adjacent incisions 510, such that all the 510 can be uniformly distributed on the packaging film 500 and the stress release effect can be improved. In an exemplary embodiment, the detection device may be a laser sensor, an infrared sensor, an ultrasonic sensor, for example. The detecting device may determine the working status of the insert 300 by detecting the position of the insert 300.

It can be understood that, in order to prevent the damage of the insert 300 due to a rigid collision with loading platform 100 after cutting, a buffer layer may be disposed on the loading platform 100. For example, the buffer layer may be made from a pad or film of flexible material.

Specifically, as shown in FIG. 5, the rotary mechanism 200 includes a rotary pillar 210 and a rotatable shaft 220. One end of the rotary pillar 210 is rotatably connected to the loading platform 100. The rotatable shaft 220 is rotatably connected to the rotary pillar 210. An axis of the rotatable shaft 220 is perpendicular to an axis of the rotary pillar 210. One end of the insert 300 is connected to the rotatable shaft 220. As a result, the rotary pillar 210 can be rotated on a horizontal surface to adjust the angle, and the insert 300 can be rotated on a vertical surface along with the rotatable shaft 220 to cut the packaging film 500.

Further, as shown in FIG. 5, the rotary mechanism 200 further includes a fixed shaft 230 fixedly disposed at an end of the rotatable shaft 220 such that an axis of the fixed shaft 230 is perpendicular to the axis of the rotatable shaft 220. One end of the insert 300 is rotatably connected to the fixed shaft 230. Specifically, one end of the insert 300 is provided with a U-shaped notch. A width of the U-shaped notch is greater than a diameter of the rotatable shaft 220. The U-shaped notch is provided with rotating holes on both side walls. The insert 300 can be rotatably connected to the fixed shaft 230 through the rotating hole, such that the insert 300 can be rotated in a plane perpendicular to the axis of the fixed shaft 230 to adjust the cutting angle of the insert 300.

Specifically, as shown in FIG. 2, in order to improve the cutting efficiency, two inserts that are centro-symmetrically arranged about the axis of the rotary pillar 210 can be provided.

In order to obtain the incisions 510 having different lengths and different angles, there is a predetermined angular range between the two inserts 300. Preferably, the angle between the two inserts 300 ranges from 30° to 150° such that the two inserts 300 can be rotatably adjusted within this angle range to meet the cutting requirements of different packaging films 500.

Further, as shown in FIG. 6, the stress release device of the packaging film of flexible photovoltaic module further includes a handle 400. The handle 400 includes a first arc segment 410 and a second arc segment 420. One end of the first arc segment 410 is fixedly connected to one insert 300, the other end of the first arc segment 410 is slidably connected to one end of the second arc segment 420, and the other end of the second arc segment 420 is fixedly connected to the other insert 300. The relative sliding between the arc section 410 and the second arc section 420 can achieve the adjustment of the length of the handle 400, thereby realizing the adjustment of the angle between the two inserts 300. At the same time, the operator can control the rotation of the inserts 300 through the handle 400, thereby facilitating his or her operation.

Specifically, as shown in FIG. 6, a chute 411 is disposed on the first arc segment 410, and a position scale 412 is disposed on an edge of the chute 411. A guide tab 421 is disposed at an end of the second arc section 420 close to the first arc section 410, and the guide tab 421 is slidably connected to the chute 411. A pointer 422 is disposed at an end of the guide tab 421 and is aligned with a scale on the position scale 412. The chute 411 has a certain length which defines an adjustable angle range between the two inserts 300. In this embodiment, the length of the chute 411 limits the angle between the two inserts 300 to 30° to 150°. In addition, by providing the pointer 422 and the position scale 412, the accuracy of the length adjustment of the handle 400 can be improved, and then the accuracy of the angle adjustment between the two inserts 300 can be improved. At the same time, the arrangement of the pointer 422 on the guide tab and the scale of the position scale 412 on the edge of the chute 411 can also facilitate reading of the scale value by the operator.

Further, an angle scale 110 is disposed around the rotary pillar 210 on the loading platform 100. One end of the rotary pillar 210 close to the loading platform 100 is provided with an indicating protrusion aligned with a scale on the angle scale 110. In this way, the accuracy of the rotation angle of the rotary pillar 210 can be improved, and then the accuracy of the cutting angle of the insert 300 can be improved.

The stress release method and device of the packaging film of flexible photovoltaic module according to the embodiments of the present disclosure can realize the release of the stress and shrinkage of the packaging film without changing the amount of the material of the packaging film, such that the risk of wrinkling during subsequent processing can be reduced. At the same time, through the automatic feeding of the packaging film, the cutting efficiency and cutting accuracy of the packaging film can be improved, the uniformity of the distribution of the incisions can be ensured, and the stress releasing effect can be enhanced.

The structure, features, and effects of the present disclosure have been described in detail with reference to the embodiments shown in the accompanying drawings. The above embodiments are only preferred embodiments of the present disclosure, but the implementation scope of the disclosure is not limited to the accompanying drawings as shown. Any changes made in the concepts of the present disclosure, or equivalent embodiments that are modified to equivalent variations, should still fall within the protection scope of the present disclosure if they do not go beyond the spirit covered by the description and the drawings.

## Claims

1. A stress release method for packaging film of flexible photovoltaic module, comprising steps of:
placing (S100) a film (500) to be cut on a loading platform (100); and
cutting (S200) the film (500) with an insert (300) such that an incision (510) inclined relative to an edge of the film (500) is formed on the film (500).

2. The stress release method for packaging film of flexible photovoltaic module according to claim 1, wherein the step of placing (S100) a film (500) to be cut on a loading platform (100) comprises:
placing the film (500) to be cut onto a feeding mechanism.

3. The stress release method for packaging film of flexible photovoltaic module according to claim 2, wherein after cutting (S200) the film (500) with an insert (300) such that an incision (510) inclined relative to an edge of the film is formed on the film, the method further comprises:
activating (S300) the feeding mechanism and driving the film (500) to move along an axial direction thereof such that the insert (300) moves out of the incision (510) to a next position to be cut on the film (500).

4. The stress release method for packaging film of flexible photovoltaic module according to claim 1, wherein before placing (S100) a film to be cut on a loading platform (100), the method further comprises:
rolling (S1) the film (500) into a cylinder-shaped film roll.

5. The stress release method for packaging film of flexible photovoltaic module according to claim 3, wherein the step of cutting (S200) the film with an insert (300) comprises:
rotating (S220) the insert (300) disposed on a rotary mechanism along a direction of the film to form the incision (510) on the film (500); and
rotating (S230) the insert (300) along a direction away from the film (500), after the incision (510) is formed.

6. The stress release method for packaging film of flexible photovoltaic module according to claim 5, wherein before rotating (S220) the insert (300) disposed on a rotary mechanism along a direction of the film to form the incision (510) on the film (500), the method further comprises:
rotating (S210) the rotary mechanism to adjust a cutting angle of the insert (300).

7. The stress release method for packaging film of flexible photovoltaic module according to claim 6, wherein before rotating (S210) the rotary mechanism to adjust a cutting angle of the insert (300), the method further comprises:
adjusting (S10) a length of a handle to adjust an angle between two inserts (300).

8. The stress release method for packaging film of flexible photovoltaic module according to claim 7, wherein the step of activating (S300) the feeding mechanism and driving the film (500) to move along an axial direction thereof such that the insert (300) moves out of the incision (510) to a next position to be cut on the film (500) comprises:
sending (S310) an insert return signal from a detection device to a stepper motor; and
activating (S320) the stepper motor to drive a clamping structure to move a predetermined step.

9. A stress release device for packaging film of flexible photovoltaic module, comprising:
a loading platform (100), configured to support a film (500); and
an insert (300), configured to cut on the (500) to form an incision (510) inclined with respect to an edge of the film (500).

10. The stress release device for packaging film of flexible photovoltaic module according to claim 9, further comprising a rotary mechanism (200) rotatably disposed on the loading platform (100), and
one end of the insert (300) is rotatably connected to the rotary mechanism (200), such that an angle is formed between the insert (300) and the rotary mechanism (200).

11. The stress release device for packaging film of flexible photovoltaic module according to claim 10, wherein the rotary mechanism (200) comprises a rotary pillar (210) and a rotatable shaft (220), and
wherein one end of the rotary pillar (210) is rotatably connected to the loading platform (100), the rotatable shaft (220) is rotatably connected to the rotary pillar (210), an axis of the rotatable shaft (220) is perpendicular to an axis of the rotary pillar (210), and one end of the insert (300) is connected to the rotatable shaft (220).

12. The stress release device for packaging film of flexible photovoltaic module according to claim 11, wherein the rotary mechanism (200) further comprises a fixed shaft (230) fixedly disposed at an end of the rotatable shaft (220) such that an axis of the fixed shaft (230) is perpendicular to the axis of the rotatable shaft (220), and
one end of the insert (300) is rotatably connected to the fixed shaft (230).

13. The stress release device for packaging film of flexible photovoltaic module according to claim 12, wherein two inserts (300) that are centro-symmetrically arranged about the axis of the rotary pillar (210) are provided.

14. The stress release device for packaging film of flexible photovoltaic module according to claim 13, wherein an angle between the two inserts (300) ranges from 30° to 150°.

15. The stress release device for packaging film of flexible photovoltaic module according to claim 14, further comprising a handle (400) having a first arc segment (410) and a second arc segment (420), wherein one end of the first arc segment (410) is fixedly connected to one insert (300), the other end of the first arc segment (410) is slidably connected to one end of the second arc segment (420) and the other end of the second arc segment (420) is fixedly connected to the other insert (300).

16. The stress release device for packaging film of flexible photovoltaic module according to claim 15, wherein a chute (411) is disposed on the first arc segment (410), and a position scale (412) is disposed on an edge of the chute (411);
a guide tab (421) is disposed at an end of the second arc section (420) close to the first arc section (410), and is slidably connected to the chute (411); and
a pointer (422) is disposed at an end of the guide tab (421) and the is aligned with a scale on the position scale (412).

17. The stress release device for packaging film of flexible photovoltaic module according to claim 16, wherein an angle scale (110) is disposed around the rotary pillar (210) on the loading platform (100), and one end of the rotary pillar (210) close to the loading platform (100) is provided with an indicating protrusion aligned with a scale on the angle scale (110).

18. The stress release device for packaging film of flexible photovoltaic module according to claim 17, wherein a buffer layer is disposed on the loading platform (100).

19. The stress release device for packaging film of flexible photovoltaic module according to any one of claims 9-18, wherein the loading platform (100) is provided with a feeding mechanism comprising a stepper motor, a detection device, and a clamping structure;
the loading platform (100) is provided with a chute feeder;
the stepper motor is configured to drive the clamping structure to slide in the chute feeder;
the detection device is fixed on the loading platform (100); and
the detection device is configured to detect a position of the insert (300).
